(19)

Europäisches Patentamt

European Patent Office

Office européen des brevets

(11) **EP 3 905 860 A1**

(12) **EUROPEAN PATENT APPLICATION**

(43) Date of publication:
03.11.2021 Bulletin 2021/44

(51) Int Cl.:
***H05K 3/28*** (2006.01)

(21) Application number: 21170659.3

(22) Date of filing: 27.04.2021

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 28.04.2020 JP 2020079436

(71) Applicant: Kyocera Corporation
Kyoto-shi,
Kyoto 6128501 (JP)

(72) Inventors:
• FUJIWARA, Masakazu
Kyoto, 6128501 (JP)
• TANAKA, Masashi
Kyoto, 6128501 (JP)

(74) Representative: Viering, Jentschura & Partner mbB
Patent- und Rechtsanwälte
Am Brauhaus 8
01099 Dresden (DE)

(54) **MANUFACTURING METHOD OF ELECTRONIC COMPONENT**

(57) A manufacturing method of an electronic component including a substrate, components provided on the substrate, and a sealing material comprising a cured material of a resin sheet covering the substrate and the components includes a first step of peeling a first release film provided on a resin sheet, disposing a surface from which the first release film is peeled, of the resin sheet, on the substrate where the components is provided, and peeling a second release film provided on a surface on an opposite side to the surface from which the first release film is peeled, of the resin sheet, a second step of pressing the resin sheet disposed on the substrate by an elastic resin plate, and temporarily fixing the resin sheet, and the substrate and the components, and a third step of heating and curing the resin sheet that is temporarily fixed to the substrate and the components to seal the substrate and the components.

EP 3 905 860 A1

**Description**

Field of the Invention

The present disclosure relates to a manufacturing method of an electronic component.

Background of the Invention

Conventionally, the installation locations of in-vehicle circuit devices and the like have been selected so that the electronic circuits are not damaged by the intrusion of water, oil, dust, and the like. Further, the structures that seal circuit substrate with a metal, and seal circuit substrate with a resin have been adopted. In the case of sealing with a resin, a transfer molding method using a solid epoxy resin composition, a potting method using a liquid epoxy resin composition, a silicone resin or the like, a dispense method, a printing method and the like are proposed (see PTL 1).

Citation List

Patent Literatures

PTL 1: JP 6-61372 A

Summary of the Invention

A manufacturing method of an electronic component of the present disclosure is a manufacturing method of an electronic component including a substrate, components provided on the substrate, and a sealing material comprising or consisting essentially of or consisting of a cured material of a resin sheet covering the substrate and the components, and includes a first step of peeling a first release film provided on a resin sheet, disposing a surface from which the first release film is peeled, of the resin sheet, on the substrate where the components is provided, and peeling a second release film provided on a surface on an opposite side to the surface from which the first release film is peeled, of the resin sheet, a second step of pressing the resin sheet disposed on the substrate by an elastic resin plate, and temporarily fixing the resin sheet, and the substrate and the components, and a third step of heating and curing the resin sheet that is temporarily fixed to the substrate and the components to seal the substrate and the component.

Brief Description of the Drawings

Fig. 1 is a schematic view illustrating one embodiment of an elastic resin plate used in a manufacturing method of an electronic component of the present disclosure;
Fig. 2 is an explanatory view illustrating a method for forming penetration portions and/or dents in a resin sheet disposed on a substrate by using the elastic resin plate;
Fig. 3 is a schematic view illustrating one embodiment of a resin sheet having a plurality of dents formed by using the elastic resin plate;
Fig. 4 is a sectional view illustrating a schematic configuration of one embodiment of a resin sheet used in the present disclosure; and
Fig. 5 is a sectional view illustrating a schematic configuration of one embodiment of a resin sheet used in the present disclosure.

Detailed Description of the Invention

When sealing an electronic component with a resin, there are a molding method that does not use a mold and a molding method that uses a mold. In the molding method that does not use a mold, only a necessary part can be sealed. When followability of a resin composition to members on the substrate is poor, a gap occurs between the members and the substrate, and may remain as a void. Further, when the resin composition is given flowability, heat resistance is reduced, and when the resin composition is further given flowability, the resin composition flows out, whereby the resin composition may protrude from the substrate and even the members that do not want to be sealed may be sealed. By the molding method that uses a mold, heat resistance and moisture resistance of a molded product can be enhanced. However, the spot that does not have to be sealed is sealed, and it may be impossible to reduce the weight of the molded product.

A manufacturing method of an electronic component of the present disclosure can make it difficult for voids to remain in a sealing material in a sealing process, is excellent in reliability, and can reduce weight.

Hereinafter, the present disclosure will be described in detail with reference to one embodiment.

A manufacturing method of an electronic component of the present disclosure is a manufacturing method of an electronic component including a substrate, components provided on the substrate, and a sealing material comprising or consisting essentially of or consisting of a cured material of a resin sheet covering the substrate and the components, and includes

a first step of peeling a first release film provided on a resin sheet, disposing a surface from which the first release film is peeled, of the resin sheet, on the substrate where the components is provided, and peeling a second release film provided on a surface on an opposite side to the surface from which the first release film is peeled, of the resin sheet,

a second step of pressing the resin sheet disposed on the substrate by an elastic resin plate, and temporarily fixing the resin sheet, and the substrate and the components, and

a third step of heating and curing the resin sheet that is temporarily fixed to the substrate and the components to seal the substrate and the components.

(First step)

In a first step, a first release film provided on a resin sheet is peeled first.

Next, a surface from which the aforementioned first release film is peeled, of the aforementioned resin sheet is disposed on a substrate on which the components are provided. When the resin sheet is overlaid on the substrate, the substrate may be at room temperature (15°C or more and 35°C or less) or may be heated to 80 to 95°C.

Finally, a second release film that is provided on a surface on an opposite side to the surface from which the first release film is peeled, of the aforementioned resin sheet, namely, the surface that is disposed on the substrate is peeled.

(Second step)

In a second step, the resin sheet that is disposed on the substrate by an elastic resin plate is pressed, and the resin sheet, and the substrate and the components are temporarily fixed. This makes it difficult for voids to remain in the resin sheet.

A concavo-convex shape may be formed on the surface of the elastic resin plate according to a shape of components to be sealed, and by temporary fixing by the elastic resin plate, a shape following the shape of the components that is sealed may be formed on the resin sheet. Further, spikes or protruded portions may be provided on the surface of the elastic resin plate, and by temporary fixing by the elastic resin plate, the resin sheet may have a plurality of penetration portions that are penetrated and/or a plurality of dents that are not penetrated in a thickness direction.

The elastic resin plate is not particularly limited as long as it has flexibility, but a material such as a silicone resin to which the resin sheet does not easily stick may be used.

The elastic resin plate is soft, and therefore can be properly curved. After the resin sheet is temporarily placed on a mounting substrate, the resin sheet is pressed from one end of the elastic resin plate to the other end so as to push out air in the resin sheet. The resin sheet is along a component surface of the mounting substrate. Thereby, it is possible to push out the air in the resin sheet.

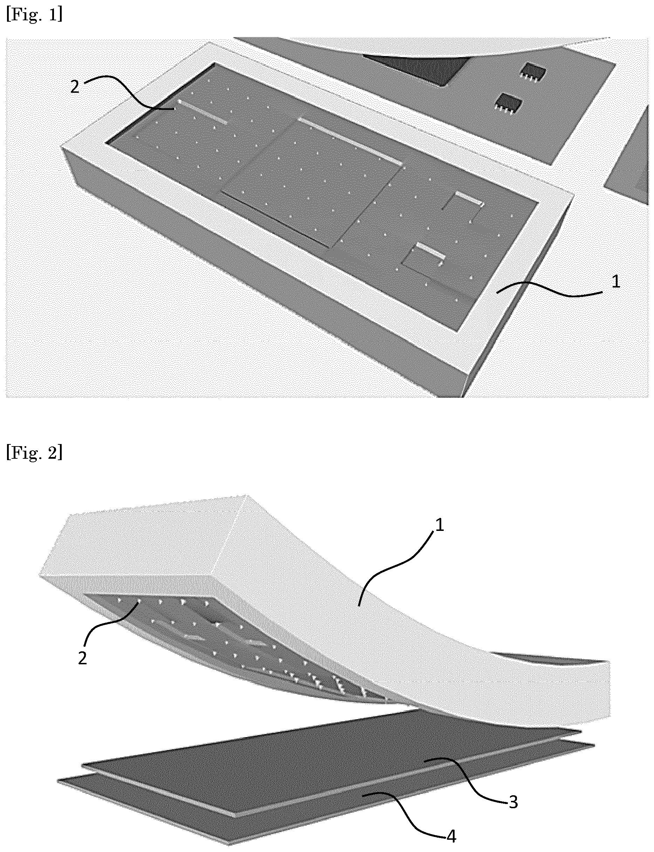

Fig. 1 is a schematic view illustrating one embodiment of the elastic resin plate. An elastic resin plate 1 illustrated in Fig. 1 is created from data of the mounting substrate. The mounting substrate data can be made from onsubstrate component CAD information, or a mounting state also can be directly converted into 3D data with a 3D scanner or the like. The 3D data can also be used to make a mold for making the elastic resin plate 1. The elastic resin plate 1 can also be produced by resin casting using the mold.

Further, the elastic resin plate 1 may be a jig for forming penetration portions and/or dents in the resin sheet.

A plurality of spike-shaped dents may be made on an inner wall of the mold for producing the elastic resin plate 1. Thereby, a plurality of spikes 2 are formed on the elastic resin plate 1 that is made by resin casting. By the spikes 2, penetration portions and/or dents can be formed in the resin sheet. Note that an appearance of the elastic resin plate 1 which is made is as in Fig. 1.

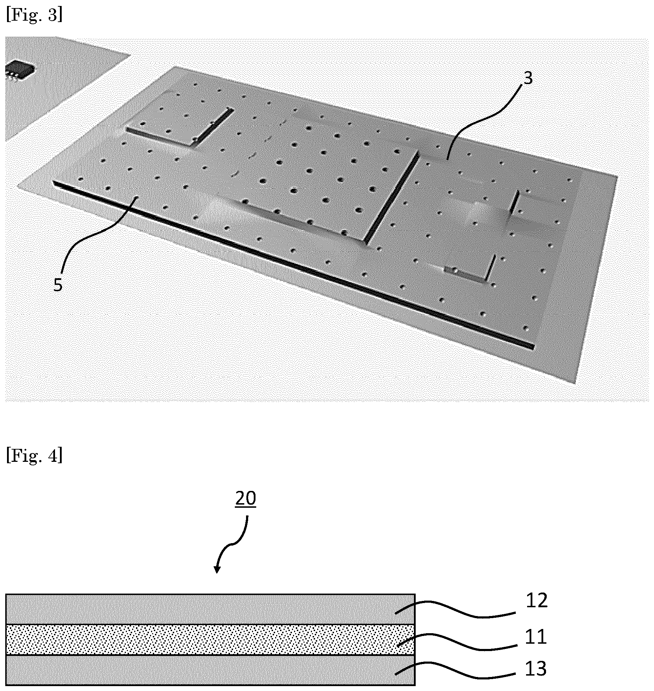

Fig. 2 is an explanatory view illustrating a method for forming penetration portions and/or dents in the resin sheet disposed on the substrate by using the elastic resin plate. Fig. 3 is a schematic view illustrating one embodiment of the resin sheet having a plurality of dents formed by using the elastic resin plate.

In the present step, as illustrated in Fig. 2, the elastic resin plate 1 presses a resin sheet 3 disposed on a substrate 4 from above the resin sheet 3, and temporarily fixes the resin sheet 3, and the substrate 4 and components (not illustrated). At the same time, the elastic resin plate 1 forms a plurality of penetration portions that are penetrated and/or a plurality of dents that are not penetrated, in a thickness direction in the resin sheet 3 by the spikes 2 that are formed.

A shape of the spikes 2 is not particularly limited, and, for example, a cylindrical shape, a polygonal prism shape, a conical shape, a groove shape and the like are cited.

When a plurality of penetration portions that penetrate in a thickness direction of the resin sheet are formed, voids can be removed from the penetration portions, which can make it difficult for voids to remain in a cured material of the resin sheet, when the resin sheet is caused to adhere onto the substrate and is heated and cured in a third step described later. Further, when a plurality of dents that are not penetrated in the thickness direction of the resin sheet are formed, a thickness of the dent portions of the resin sheet becomes small, so that voids easily escape at a melting time, the resin sheet easily follows the components, which can make it difficult for voids to remain in the cured material of the resin sheet.

A shape of the penetration portion is not particularly limited, and may be a through-hole or through-groove.

A number and positions of the through-holes provided in the resin sheet differ according to a size of the substrate that is used, shapes and a number of components that are mounted, and therefore are not particularly limited. A ratio of a total area of the through-holes may be 1 to 20% of a surface area of the resin sheet, from a viewpoint of reducing voids.

Further, a groove length and a number of through-grooves that are provided in the resin sheet differ according to a size of the substrate that is used, shapes and a number of components that are mounted, and therefore are not particularly limited. A ratio of a total area of the grooves may be 1 to 20% of the surface area of the resin sheet, from the viewpoint of reducing voids. Positions of the through-grooves provided in the resin sheet are not particularly limited, and the through-grooves may be provided parallel to one side of the resin sheet.

A shape of the dent is not particularly limited, and, for example, a cylindrical shape, a polygonal prism shape, a conical shape, a groove shape and the like are cited. A shape of a bottom portion of the dent may be a curved shape.

When a through-hole having a section in a taper shape is formed in a thickness direction of the resin sheet, a narrower opening portion (lower hole) is formed in a surface disposed on the substrate, of the resin sheet, and a wider opening portion (upper hole) is formed in a surface on an opposite side to the surface disposed on the substrate, of the resin sheet.

The through-hole may be formed so that an area of the lower hole is 50% or more smaller than an area of the upper hole. By forming the area of the lower hole to be 50% or more smaller than the area of the upper hole, voids can be removed from the upper hole when the resin sheet is heated and melted, which can make it difficult for voids to remain in the cured material of the resin sheet.

Further, a lower hole diameter of the through-hole that is formed may be 10 to 50% of a thickness of the resin sheet. When the lower hole diameter is 10% or more of the thickness of the resin sheet, air bubbles sufficiently escapes, and when the lower hole diameter is 50% or less of the thickness of the resin sheet, the resin can sufficiently fill the hole.

Further, when the through-groove formed in the thickness direction of the resin sheet has a section in a taper shape, a groove width on a wider side of the taper shape may be 10 to 50% of the thickness of the resin sheet. When the groove width is 10% or more of the thickness of the resin sheet, air bubbles sufficiently escape until the through-groove is blocked, which can make it difficult for voids to remain in the cured material of the resin sheet, whereas when the groove width is 50% or less of the thickness of the resin sheet, the resin can sufficiently fill the groove.

(Third step)

In a third step, the resin sheet that is temporarily fixed to the substrate and the components is heated and cured to seal the substrate and the components.

The heating and curing are normally performed at normal pressure (no pressurization), but may be performed in a vacuum heating furnace. A heating temperature may be 80 to 150°C, or may be 90 to 120°C. A heating time period may be 10 minutes to 2.0 hours, or may be 30 minutes to 1.0 hour.

Sealing of the components by the resin sheet can also be performed, for example, by temporarily causing the resin sheet to adhere to the components by performing heating and curing, or press molding or thermal laminate molding at a low pressure of 0.5 MPa or less, and thereafter heating and curing the resin sheet. As laminate conditions at this time, favorable temporarily adhering body is obtained by, for example, being passed through a heating and pressuring roll at a speed of 0.1 to 5 m/minute, in a temperature range of 30 to 180°C.

The electronic components obtained in this way can be used for consumer use, in-vehicle use, industrial use, and the like. Specifically, the electronic components can be used in control circuit devices installed in an engine room, a transmission and the like for automobile, and a control circuit device for motorcycle.

The electronic component obtained by the manufacturing method of an electronic component of the present disclosure includes a substrate, components provided on the substrate, and a sealing material that covers the substrate and the components.

As the substrate, for example, a metal substrate of an aluminum, an iron plate or the like, a ceramics substrate, an organic resin substrate formed by immersing a thermosetting resin in a glass fiber base material and curing it, and the like are cited. Above all, from viewpoints of processability, cost reduction, and affinity with the sealing material, the substrate may be an organic resin substrate formed by immersing a thermosetting resin in a glass fiber base material and curing it. Further, the substrate may have a solder resist on a surface.

The substrate may be a circuit substrate with a patterned conductor layer (circuit) formed on one surface or both surfaces. As for a manufacturing method of a circuit substrate, any manufacturing method that has been performed conventionally and forms a circuit is usable.

As components covered with the sealing material in the components, for example, devices such as a semiconductor device, a resistor, a diode, a capacitor, a high frequency device, and an acceleration sensor are cited. Further, as components that are not covered with the sealing material, for example, heat radiation members, through-holes, open holes and the like are cited.

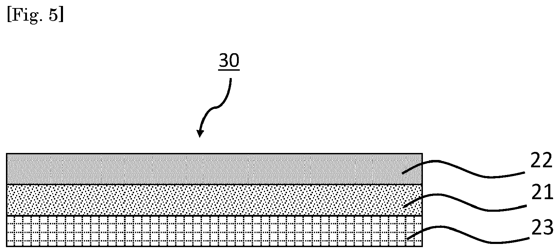

The sealing material is formed of a cured material of the resin sheet. Fig. 4 and Fig. 5 are sectional views each illustrating a schematic configuration of one embodiment of the resin sheet. Here, in the present disclosure, as illustrated in Fig. 4 and Fig. 5, a sheet provided with other films such as a release film and/or a thermoplastic film on the resin sheet is referred to as a sealing sheet.

As illustrated in Fig. 4, a resin sheet 11 used in the present disclosure may be provided with a release film 12 on a first surface. Further, a second release film 13 may also be provided on a surface on an opposite side to the first release film 12 of the resin sheet 11. Note that a sealing sheet 20 may be stored by being stacked, but may be rolled up and used in a roll shape.

As illustrated in Fig. 5, a sealing sheet 30 may be provided with a first release film 22 on a first surface of a resin sheet 21, and a thermoplastic film 23 may be provided on a surface on an opposite side to the first release film 22, of the resin sheet 21. Here, the resin sheet 21 may be integrated with the thermoplastic film 23. Further, the resin sheet 21 may be formed in close contact with the first release film 22.

By sealing components on a substrate surface or the like with the sealing sheet 30, surface protection performance such as heat resistance, abrasion resistance, water resistance, and oil resistance is enhanced, and long-term reliability of the components is enhanced.

The resin sheet may be a sheet consisting of a thermosetting resin composition. The thermosetting resin composition is not particularly limited, and as a thermosetting resin contained in the thermosetting resin composition, for example, an epoxy resin, an acrylic resin, an urethane resin, a melamine resin, a phenol resin and the like are cited. The thermosetting resin composition may contain an epoxy resin, and may contain (A) epoxy resin, (B) epoxy resin curing agent, (C) curing accelerator, and (D) inorganic filler.

The epoxy resin of the (A) component is not particularly limited, and may contain (A-1) liquid bisphenol type epoxy resin and (A-2) solid multi-functional epoxy resin with a softening point of 95°C or less.

The liquid bisphenol type epoxy resin of the (A-1) component is not particularly limited as long as it is a liquid bisphenol type compound having two or more epoxy groups in one molecule, and for example, bisphenol A type and bisphenol F type are cited. As specific examples of the liquid bisphenol A type epoxy resin, "EPOMIK (registered trademark) R140P (epoxy equivalent 188)" made by Mitsui chemicals, Inc., "DER383 (epoxy equivalent 190)" made by The Dow Chemical Company, "jER (registered trademark) 807 (epoxy equivalent 170)" and "jER (registered trademark) 828 (epoxy equivalent 190)" made by Mitsubishi Chemical Corporation and the like are cited.

One kind of these liquid bisphenol type epoxy resins may be used, or two kinds or more of these liquid bisphenol type epoxy resins may be used in combination.

Note that in the present disclosure, the liquid bisphenol type epoxy resin refers to a bisphenol type epoxy resin that is liquid at 25°C.

A softening point of the solid multi-functional epoxy resin of the (A-2) component is 95°C or less. When the softening point of the solid multi-functional epoxy resin of the (A-2) component becomes higher than 95°C, cracks and chips easily occur to the resin sheet. From a viewpoint like this, the softening point of the (A-2) component may be 80°C or less, or may be 70°C or less. Further, a lower limit of the softening point of the (A-2) component is normally around 40°C.

Note that the softening point in the present disclosure can be measured based on the softening point test method (ring-and-ball method) defined by JIS K2207. Specifically, a specimen is filled in a specified ring, which is horizontally supported in a water bath or glycerin bath, a specified ball is placed in a center of the specimen to increase a bath temperature at a speed of 5°C per minute, and a temperature that is read when the specimen wrapping the ball contacts a bottom plate of a ring stand is the softening point.

As the solid multi-functional epoxy resin of the (A-2) component with the softening point of 95°C or less, for example, a mixture of a biphenyl backbone-containing aralkyl type epoxy resin, a mixture of a dicyclopentadiene type epoxy resin and the like are cited. As a commercially available solid multi-functional epoxy resin with the softening point of 95°C or less, "NC3000 (softening point 57°C)" and "NC3000H (softening point 70°C)" made by Nippon Kayaku Co., Ltd., "YDCN704 (softening point 90°C)" made by NIPPON STEEL Chemical & Material Co., Ltd., and the like are cited.

By using the (A-1) liquid bisphenol type epoxy resin and (A-2) solid multi-functional epoxy resin with the softening point of 95°C or less in combination, that is, by compounding two kinds of epoxy resins differing in melting point, it is possible to obtain a thermosetting resin composition that behaves as a solid at a room temperature (25°C) and as a liquid at high temperatures.

A mass ratio [(A-1) / (A-2)] of the (A-1) component and (A-2) component may be in a range of 10/90 to 30/70. When the mass ratio [(A-1) / (A-2)] is 10/90 or more, cracks and chips hardly occur in the resin sheet, and when the mass ratio [(A-1) / (A-2)] is 30/70 or less, the resin sheet can be easily formed.

An epoxy resin content of the (A) component may be 50 to 90% by mass in the whole amount of the thermosetting resin composition, and may be 60 to 80% by mass. When the content of the epoxy resin of the (A) component is 50% by mass or more, cracks and chips hardly occur in the resin sheet, flowability at a melting time is enhanced, and it is possible to make it difficult for unfilled spots to occur in gaps. Further, when the content of the epoxy resin of the (A) component is 90% by mass or less, flowability of the molten resin does not become too high and it is possible to make it difficult for the molten resin to protrude from the range to be sealed, when the substrate and components are sealed by using the resin sheet.

The epoxy resin curing agent of the (B) component is not particularly limited, and it is possible to select and use an arbitrary curing agent properly from the curing agents that have been conventionally used as the curing agents of the epoxy resins, and for example, an amine-based curing agent, a phenol-based curing agent, an acid anhydride-based curing agent and the like are cited. As the amine-based curing agent, for example, aromatic diamines such as dicyandiamide, m-phenylenediamine, 4,4'-diaminodiphenylmethane, 4,4'-diaminodiphenylsulfone, and m-xylylene diamine and the like are cited. As the phenol-based curing agent, for example, a phenolic novolac resin, cresol novolac resin, bisphenol A type novolac resin, triazine-modified phenol novolac resin, and the like are cited. Further, as the acid anhydride-based curing agent, for example, an alicyclic acid anhydride such as methylhexahydrophthalic acid anhydride, an aromatic acid anhydride such as phthalic acid anhydride, an aliphatic acid anhydride such as aliphatic dibasic acid anhydride (PAPA), a halogen acid anhydride such as chlorendic acid anhydride and the like are cited. One kind of these epoxy resin curing agents may be used, or two kinds or more of these epoxy resin curing agents may be used in combination.

A content of the epoxy resin curing agent of the (B) component may normally be about a 0.5 to 1.5 equivalent ratio in an equivalent ratio to the epoxy resin of the (A) component, or may be selected in a range of an equivalent ratio of 0.7 to 1.3, from a viewpoint of balance of curability and cured resin physical properties.

The curing accelerator of the (C) component is not particularly limited, and it is possible to select and use arbitrary one from the curing accelerators that have conventionally been used as the curing accelerators for epoxy resins. For example, it is possible to illustrate ureas such as aromatic dimethylurea, aliphatic dimethylurea, 3-(3,4-dichlorophenyl)-1,1-dimethylurea (DCMU), 3-(3-chloro-4-methylphenyl)-1,1-dimethylurea, and 2,4-bis (3,3-dimethylureido) toluene, imidazole compounds such as 2-ethyl-4-methylimidazole, 1-benzyl-2-methylimidazole, 2-methylimidazole, 2-ethylimidazole, 2-isopropylimidazole, 2-phenylimidazole, and 2-phenyl-4-methylimidazole, 2,4,6-tris(dimethylaminomethyl) phenol, boron trifluoride amine complex, triphenylphosphine and the like. One kind of these curing accelerators may be used, or two kinds or more of these curing accelerators may be used in combination.

A content of the curing accelerator of the (C) component may normally be around 0.1 to 10 parts by mass to 100 parts by mass of the epoxy resin of the (A) component, and may be selected in a range of 0.4 to 5 parts by mass, from a viewpoint of a balance of curing acceleration property and cured resin physical properties.

The inorganic filler of the (D) component is not particularly limited, and, for example, it is possible to use inorganic fillers that are normally used such as silicas such as molten silica, spherical silica and crystal silica; alumina; and metal hydrates such as aluminum hydroxide, and magnesium hydroxide.

A mass average particle size of the inorganic filler of the (D) component may be in a range of 1 to 30 $\mu$m, and may be in a range of 1.5 to 20 $\mu$m from a viewpoint of workability at a manufacturing time and efficiency of filling the thermosetting resin composition into the gaps. Note that in the present disclosure, the mass average particle size indicates a median value (D50) measured by a laser diffraction and scattering method (for example, equipment name: SALD-3100 made by Shimadzu Corporation).

The inorganic filler of the (D) component may be aluminum hydroxide, spherical silica, and crystal silica. As the aluminum hydroxide, "H42M (mass average particle size: 1.5 $\mu$m)" made by Showa Denko K. K. is cited. As the spherical silica, "MRS-15 (mass average particle size: 15 $\mu$m)" made by Tatsumori Co., Ltd. and "FB-959 (mass average particle size: 25 $\mu$m)" made by Denka Company Limited are cited. As the crystal silica, "FUSELEX RD-8 (mass average particle size: 18 $\mu$m)" made by Tatsumori Co., Ltd. is cited. Note that the metal hydrate is also used as a flame retardant, but in the present disclosure, the metal hydrate is dealt as the inorganic filler of the (D) component.

A content of the inorganic filler of the (D) component may be 10 to 80% by mass, may be 10 to 60% by mass, may be 10 to 50% by mass, and may be 20 to 40% by mass, in the whole amount of the thermosetting resin composition. When the content of the inorganic filler of the (D) component is 10% by mass or more, flowability at the melting time does not become too high, the thermosetting resin composition can be prevented from protruding from the range to be sealed (sealed region), and it is possible to make it difficult for warping and twisting to occur when the thermosetting resin composition is cured. When the content of the inorganic filler of the (D) component is 80% by mass or less, flowability at the melting time is improved, and it becomes difficult for unfilled spots to occur in the sealed region.

In the thermosetting resin composition, a content of the (A) component, (B) component, (C) component and (D) component may be 70% by mass or more, may be 80% by mass or more, or may be 90% by mass or more.

The thermosetting resin composition can properly contain a coupling agent such as a silane-based coupling agent, titanate-based coupling agent, and aluminum-based coupling agent; a flame retardant such as a phosphazene compound, 9,10-dihydro-9-oxa-10-phosphaphenanthrene-10-oxide and its derivatives, a phosphate ester compound, and phosphate ester amide; a low stress agent such as organic powder of silicone rubber, silicone gel and the like, and a thermoplastic resin such as a silicone modified epoxy resin, phenol resin, and methyl methacrylate-butadiene-styrene copolymer; a diluent for reducing viscosity such as n-butyl glycidyl ether, phenyl glycidyl ether, styrene oxide, t-butyl phenyl glycidyl ether, dicyclopentadiene diepoxide, phenol, cresol, and t-butyl phenol; a wetting improver such as a nonionic surfactant, a fluorine-based surfactant, and silicone oil, an antifoaming agent and the like in such a range that does not deviate from the gist of this disclosure.

The resin sheet may be a resin sheet obtained by superposing and integrating two or more layers of resin sheets having different compositions, and for example, resin sheets having different amounts of an inorganic filler or the like may be combined.

(Preparation of thermosetting resin composition)

A preparation method of the thermosetting resin composition is not particularly limited, and it is possible to prepare it as follows, for example. First, (A-1) liquid bisphenol type epoxy resin and (A-2) solid multi-functional epoxy resin with the softening point of 95°C or less as the aforementioned (A) component, (B) epoxy resin curing agent, (C) curing accelerator, (D) inorganic filler, and various arbitrary components that are added in addition as necessary are mixed uniformly by a high-speed mixer or the like, and thereafter are sufficiently kneaded by a kneader, two rolls, a continuous kneading device or the like. A kneading temperature may be around 50 to 110°C.

The kneaded material obtained in this way is cooled and thereafter pulverized to obtain a lump resin. Note that when a sheet-shaped thermosetting resin composition is used in formation of the resin sheet, the kneaded material is pressed to be molded into a sheet shape under conditions of a temperature of around 50 to 100°C, and pressure of 0.5 to 1.5 MPa by a molding machine.

A thickness of the aforementioned resin sheet may be 30 to 2000 μm, or may be 100 to 1000 μm. When the thickness of the resin sheet is 30 μm or more, for example, handleability of the thermosetting resin composition used to form the resin sheet alone becomes good. Further, when a component is manufactured by causing the resin sheet to adhere to the component body, wrinkles and cracks hardly occur to the resin sheet in particular when processing, transporting and moving the component. When the thickness of the resin sheet is 2000 μm or less, handleability is improved, cracks hardly occur to the resin sheet after cured, and it becomes easier to make components thin.

The aforementioned release film is provided on the first surface of the resin sheet, and may be formed in close contact with the resin sheet. The film base material composing the release film is not particularly limited as long as melt and deformation do not occur when the resin sheet is formed on the release film, and, for example, it is possible to use polyethylene, polystyrene, polyethylene terephthalate, methacryl, polyimide, polyether ether ketone, polycarbonate, a polyvinyl alcohol-based resin, a polypropylene-based resin, a polymethylpentene-based resin, a silicone-based resin, a fluorine-based resin and the like. As the film base material composing the release film, polyethylene terephthalate, a polyvinyl alcohol-based resin, a polypropylene-based resin, a polymethylpentene-based resin, a silicone-based resin, and a fluorine-based resin may be used.

A thickness of the release film may be 10 to 100 μm. When the thickness of the release film is 10 μm or more, wrinkles and the like hardly occur at a time of being in close contact with the resin sheet, and handleability is improved. When the thickness of the release film is 100 μm or less, peeling performance at a time of use becomes good.

The thermoplastic film is provided on the second surface of the resin sheet, and is provided on a surface of a sealing material that covers the substrate and the components of the electronic component after molding the electronic component. The thermoplastic film is not particularly limited as long as melting and deformation are within a specified range when the electronic component is molded, and, for example, heat resistant films such as a polyimide film, polyamide imide film, aramid film, and polyether ether ketone film are cited. The thermoplastic film may be a polyimide film, or a polyether ether ketone film.

As a commercially available product of a polyimide film, Kapton (registered trademark) (product name, made by DU PONT-TORAY CO., LTD), is cited, and as a commercially available product of a polyether ether ketone film, EXPPEK (product name, made by KURABO INDUSTRIES LTD.) and the like are cited.

A thickness of the thermoplastic film may be 3 to 15 μm. When the thickness of the thermoplastic film is 3 μm or more, protection of the substrate surface can be sufficiently performed. Further, when the thickness of the thermoplastic film is 15 μm or less, followability to the concave and convex of the components on the substrate becomes good when the resin sheet is caused to adhere to the substrate surface on which the components are mounted and is heated to be sealed.

(Manufacturing method of resin sheet)

The manufacturing method of the resin sheet is not particularly limited, and, for example, it is possible to manufacture the resin sheet by going through a step of obtaining a kneaded material by kneading the components of the thermosetting resin composition at a temperature of 50 to 110°C to obtain a kneaded material, and a step of supplying the kneaded material onto the release film, and pressing the release film and the kneaded material to thereby mold release film and the kneaded material into a sheet shape integrally.

Note that when a thermoplastic film is provided on a surface on an opposite side to the release film of the resin sheet, in the manufacturing method, the kneaded material is supplied between the release film and the thermoplastic film, and the release film, the kneaded material, and the thermoplastic film may be pressed to thereby mode the release film, the kneaded material and the thermoplastic film into a sheet shape integrally.

A supply form of the kneaded material is not particularly limited, and can be a lump form, a sheet form, and a molten form. Further, molding of the kneaded material and the release film may be performed by a batch method, or may be continuously performed by using thermal press, a pressurizing roll and the like.

Manufacture of the resin sheet may be performed by a method that supplies the kneaded material onto the release film, and integrally molds the release film and the kneaded material into a sheet shape by pressurizing rolls. A pair of pressurizing rolls may be the rolls that can adjust a gap size thereof, and may be the rolls with a diameter of 20 to 60 mm, and the gap size of around 5 to 500 $\mu$m, for example. Further, the molding conditions for integration may be a temperature range of 30 to 180°C, and a rotational speed of the pressurizing rolls of 0.1 to 5 m/minute. By adopting the temperature range and the rotational speed of the pressurizing rolls like them, a good resin sheet is obtained.

(Physical properties of resin sheet)

A melt viscosity at 100°C of the resin sheet may be 1.2 to 28 Pa·s, may be 4 to 18 Pa·s, and may be 7 to 12 Pa·s. When the melt viscosity at 100°C is 1.2 Pa·s or more, flowability does not become too high, and protrusion from the substrate, and sealing of the members that is not desired to be sealed can be prevented, and when the melt viscosity is 28 Pa·s or less, flowability does not become too low, and the members desired to be sealed can be sealed.

Note that the melt viscosity at 100°C can be measured by using a rheometer.

A chixo index at 100°C of the resin sheet calculated from expression (I) below may be 4 or less, may be 3.5 or less, and may be 3 or less. As a lower limit value of the chixo index at 100°C may be less than one.

$$\text{Chixo Index (-)} = \text{Melt Viscosity at 1.0 (rad/s)}/\text{Melt Viscosity at 10.0 (rad/s)}$$
$$(\text{I})$$

When the chixo index at 100°C is 4 or less, flowability of the resin sheet becomes good, and it is possible to reduce occurrence of voids.

A penetration distance of the aforementioned resin sheet measured under the following conditions may be 1 to 5 mm, may be 1 to 3 mm, and may be 1 to 2 mm.

(Measurement of penetration distance)

A distance of penetration of the resin composition melted at 100°C between glass plates provided with a clearance of 50 $\mu$m therebetween is measured.

When the penetration distance is 1 mm or more, flowability is good when the resin composition becomes a resin sheet, and it is possible to reduce occurrent of voids. Further, when the penetration distance is 5 mm or less, flowability does not become too high when the resin composition becomes a resin sheet, and it is possible to prevent protrusion from the sealed region.

Reference Signs List

| | |
|---|---|
| 1 | Elastic resin plate |
| 2 | Spike |
| 3, 11, 21 | Resin sheet |
| 4 | Substrate |

| 5 | Dent |
| 20, 30 | Sealing sheet |
| 12, 22 | First release film |
| 13 | Second release film |
| 23 | Thermoplastic film |

**Claims**

1. A manufacturing method of an electronic component comprising a substrate (4), components provided on the substrate (4), and a sealing material comprising a cured material of a resin sheet (3, 11, 21) covering the substrate (4) and the components, comprising:

   a first step of peeling a first release film (12, 22) provided on a resin sheet (3, 11, 21), disposing a surface from which the first release film (12, 22) is peeled, of the resin sheet (3, 11, 21), on the substrate (4) where the components is provided, and peeling a second release film (13) provided on a surface on an opposite side to the surface from which the first release film (12, 22) is peeled, of the resin sheet (3, 11, 21);
   a second step of pressing the resin sheet (3, 11, 21) disposed on the substrate (4) by an elastic resin plate (1), and temporarily fixing the resin sheet (3, 11, 21), and the substrate (4) and the components; and
   a third step of heating and curing the resin sheet (3, 11, 21) that is temporarily fixed to the substrate (4) and the components to seal the substrate (4) and the components.

2. The manufacturing method of an electronic component according to claim 1, wherein in the second step, simultaneously with pressing the resin sheet (3, 11, 21) disposed on the substrate (4) by the elastic resin plate (1), and temporarily fixing the resin sheet (3, 11, 21), and the substrate (4) and the components, a plurality of penetration portions that are penetrated in a thickness direction and/or a plurality of dents that are not penetrated are formed in the resin sheet (3, 11, 21).

3. The manufacturing method of an electronic component according to claim 1 or 2, wherein the elastic resin plate (1) is a jig for forming penetration portions and/or dents in the resin sheet (3, 11, 21), includes flexibility, and includes a plurality of spikes.

4. The manufacturing method of an electronic component according to any one of claims 1 to 3, wherein in the second step, the resin sheet (3, 11, 21) is pressed from one end to the other end of the elastic resin plate (1) to push out air in the resin sheet (3, 11, 21).

5. The manufacturing method of an electronic component according to any one of claims 1 to 4, wherein in the third step, curing conditions are no pressurization, a curing temperature of 80 to 150°C, and a curing time period of 10 minutes to 2.0 hours.

6. The manufacturing method of an electronic component according to any one of claims 2 to 5, wherein shapes of the penetration portions are through-holes or through-grooves.

7. The manufacturing method of an electronic component according to claim 6, wherein a ratio of a total area of the through-holes is 1 to 20% of a surface area of the resin sheet or a ratio of a total area of the through-grooves is 1 to 20% of the surface area of the resin sheet.

8. The manufacturing method of an electronic component according to claim 6 or 7, wherein the through-holes have a taper shape, a narrower opening portion of the through-holes is formed in a surface of the resin sheet disposed on the substrate, and a wider opening portion of the through-holes is formed in a surface of the resin sheet on an opposite side to the surface of the resin sheet disposed on the substrate.

9. The manufacturing method of an electronic component according to claim 8, wherein the through-holes are formed so that an area of the narrower opening portion is 50% or more smaller than an area of the wider opening portion.

10. The manufacturing method of an electronic component according to claim 8 or 9, wherein a diameter of the narrower opening portion of the through-hole is 10 to 50% of a thickness of the resin sheet.

**11.** The manufacturing method of an electronic component according to claim 6 or 7, wherein the through-grooves have a taper shape.

**12.** The manufacturing method of an electronic component according to claim 11, wherein a groove width on a wider side of the taper shape may be 10 to 50% of the thickness of the resin sheet.

**13.** The manufacturing method of an electronic component according to any one of claims 1 to 12, wherein a thickness of the resin sheet is 30 to 2000 $\mu$m.

[Fig. 1]

[Fig. 2]

[Fig. 3]

[Fig. 4]

[Fig. 5]

30

22
21
23

Europäisches
Patentamt

European
Patent Office

Office européen
des brevets

**EUROPEAN SEARCH REPORT**

Application Number

EP 21 17 0659

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 6 484061 B2 (NITTO DENKO CORP) 13 March 2019 (2019-03-13) | 1,4,5,13 | INV. H05K3/28 |
| A | * paragraphs [0038], [0046], [0049], [0085]; figures 1A-1D * | 2,3,6-12 | |
| A | EP 3 334 258 A1 (TOSHIBA KK [JP]; TOSHIBA INFRASTRUCTURE SYSTEMS & SOLUTIONS CORP [JP]) 13 June 2018 (2018-06-13) * paragraphs [0067], [0068]; figure 17 * | 1-13 | |

TECHNICAL FIELDS
SEARCHED        (IPC)

H05K

The present search report has been drawn up for all claims

| Place of search | Date of completion of the search | Examiner |
|---|---|---|
| The Hague | 9 September 2021 | Goethals, Filip |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 21 17 0659

This annex lists the patent family members relating to the patent documents cited in the above-mentioned European search report.
The members are as contained in the European Patent Office EDP file on
The European Patent Office is in no way liable for these particulars which are merely given for the purpose of information.

09-09-2021

| Patent document cited in search report | | Publication date | Patent family member(s) | | Publication date |
|---|---|---|---|---|---|
| JP 6484061 | B2 | 13-03-2019 | JP | 6484061 B2 | 13-03-2019 |
| | | | JP | 2015179829 A | 08-10-2015 |
| | | | TW | 201541577 A | 01-11-2015 |
| | | | WO | 2015129689 A1 | 03-09-2015 |
| EP 3334258 | A1 | 13-06-2018 | EP | 3334258 A1 | 13-06-2018 |
| | | | JP | 6612723 B2 | 27-11-2019 |
| | | | JP | 2018093138 A | 14-06-2018 |
| | | | US | 2018160525 A1 | 07-06-2018 |

EPO FORM P0459

For more details about this annex : see Official Journal of the European Patent Office, No. 12/82

**EP 3 905 860 A1**

**Patent documents cited in the description**

- JP 6061372 A